# EUROPÄISCHE PATENTANMELDUNG

(11) **EP 0 741 473 A1**
(43) Veröffentlichungstag der Anmeldung: **06.11.1996**
(21) Anmeldenummer: 96201208.4
(22) Anmeldetag: 02.05.1996
(51) Int. Cl.: H04L 7/033, H03L 7/099

(54) **Übertragungssystem mit einer Schaltung zur Rückgewinnung eines Taktsignals**

(30) Priorität: 05.05.1995 DE 19516107
(71) Anmelder: Philips Patentverwaltung GmbH, 22335 Hamburg (DE); PHILIPS ELECTRONICS N.V., 5621 BA Eindhoven (NL)
(72) Erfinder: Frank, Georg, Dr., 22335 Hamburg (DE); Rosenkranz, Werner, Dr., 22335 Hamburg (DE); Schinabeck, Alfons, 22335 Hamburg (DE); Skibba, Karl, 22335 Hamburg (DE)
(74) Vertreter: Volmer, Georg, Dipl.-Ing.

(57) **Zusammenfassung**

Die Erfindung bezieht sich auf ein Übertragungssystem mit einer Schaltung (3) zur Rückgewinnung eines Taktsignals aus einem digitalen Eingangssignal mittels eines digitalen Regelkreises (5). Der Regelkreis (5) enthält einen Phasendetektor (10) und eine Steuerschaltung (16). Der Phasendetektor (10) bildet aus Abtastwerten des digitalen Eingangssignals und aus Oszillatorwerten eines digitalen Oszillators (14) mindestens zwei Phasenwerten in Abhängigkeit von der Größe der Oszillatorwerte bei Auftreten eines Zustandswechsels im Eingangssignal. Die Steuerschaltung (16) legt die Dauer der Zählintervalle des digitalen Oszillators (14) in Abhängigkeit von den Phasenwerten fest.

## Beschreibung

Die Erfindung bezieht sich auf ein Übertragungssystem mit einer Schaltung zur Rückgewinnung eines Taktsignals aus einem digitalen Eingangssignal.

Ein solches Übertragungssystem dient z.B. zur Übertragung von plesiochronen Signalen oder Signalen der synchronen digitalen Hierachie (SDH). Ein Multiplexer fügt jeweils die Daten eines plesiochronen Signales in jeweils einen virtuellen Container (z.B. virtueller Container VC-2) und bildet aus der Gesamtheit der virtuellen Container ein STM-1-Signal (STM = synchrones Transportmodul). Hierbei muß jeweils eine Anpassung zwischen dem aus dem ankommenden plesiochronen Signal abgeleiteten Taktsignal und einem lokalen Taktsignal durchgeführt werden. Um ein Taktsignal aus dem ankommenden Eingangssignal abzuleiten, ist eine Schaltung zur Rückgewinnung eines Taktsignals erforderlich.

Der Erfindung liegt daher die Aufgabe zugrunde, eine Schaltung zur Rückgewinnung eines Taktsignals für das Übertragungssystem zu schaffen.

Die Aufgabe wird durch ein Übertragungssystem der eingangs genannten Art gelöst, das folgende Merkmale aufweist:
Das Übertragungssystem enthält eine Schaltung zur Rückgewinnung eines Taktsignals aus einem digitalen Eingangssignal mittels eines digitalen Regelkreises.
Der digitale Regelkreises enthält
- einen Phasendetektor zum Empfang von Eingangswerten, die aus Abtastwerten des digitalen Eingangssignals abgeleitet sind, und von Oszillatorwerten eines digitalen Oszillators und zur Erzeugung von mindestens zwei Phasenwerten in Abhängigkeit von der Größe der Oszillatorwerte bei Auftreten eines Zustandswechsels in der Folge der Eingangswerte und
- eine Steuerschaltung, welche zur Festlegung der Dauer der Zählintervalle des digitalen Oszillators in Abhängigkeit von den Phasenwerten vorgesehen ist.

Das erfindungsgemäße Übertragungssystem enthält eine Schaltung zur Rückgewinnung eines Taktsignals, welche vollständig aus digitalen Schaltungselementen zusammengesetzt ist. Ein Phasendetektor in der Schaltung zur Rückgewinnung eines Taktsignals empfängt aus Abtastwerten eines digitalen Eingangssignals abgeleitete Eingangswerte. Die Abtastfrequenz, mit der die Abtastwerte erzeugt werden, ist deutlich größer als die Nennfrequenz des zu erzeugenden Taktsignals. Der Phasendetektor vergleicht die Größe eines von einem digitalen Oszillator stammenden Oszillatorwertes mit mindestens einem Vergleichswert, wenn die Folge der Eingangswerte einen Zustandswechsel angibt. Der Phasendetektor gibt beispielsweise einen positiven Phasenwert aus, wenn der Oszillatorwert den Vergleichswert überschreitet. Der Phasenwert Null wird vom Phasendetektor erzeugt, wenn der Vergleichswert gleich dem Oszillatorwert ist. In den anderen Fällen wird ein negativer Phasenwert vom Phasendetektor gebildet. Statt der drei Phasenwerte können auch zwei Phasenwerte gebildet werden. So könnte beispielsweise bei Gleichheit von Oszillatorwert und Vergleichswert ein positiver Phasenwert vom Phasendetektor ausgegeben werden.

Aus den Phasenwerten bildet die Steuerschaltung Steueranweisungen für den digitalen Oszillator, der beispielsweise als Zähler ausgebildet sein kann. Die Steuerschaltung gibt die Zählintervalle für den digitalen Oszillator an. Ist die Abtastfrequenz beispielsweise gleich 19,44 MHz und die Nennfrequenz des zurückzugewinnenden Taktsignals soll 2,048 MHz betragen, so werden von der Steuerschaltung in Abhängigkeit von den Phasenwerten die Zählintervalle 9 und 10 erzeugt, weil das Verhältnis der beiden Frequenzen ungefähr 9,5 ist. Ein als digitaler Oszillator ausgebildeter Zähler wird dabei mit einem Taktsignal getaktet, dessen Abtastfrequenz 19,44 beträgt. Dem digitalen Oszillator können auch beispielsweise drei unterschiedliche Zählintervalle geliefert werden, wenn das Verhältnis zwischen Abtastfrequenz und Nennfrequenz ungefähr gleich dem mittleren der drei Zählintervalle ist.

Außer der rein digitalen Bauweise der Schaltung zur Rückgewinnung eines Taktsignals weist diese auch ein gutes Jitterverhalten aus. Beispielsweise wird der Jitter in dem Ausgangssignal eines Multiplexers nicht wesentlich erhöht.

Wie oben schon aufgeführt ist in einer Ausführungsform des Phasendetektors vorgesehen, daß dieser bei Auftreten eines Zustandswechsels in der Folge der Eingangswerte den anliegenden Oszillatorwert mit einem Vergleichswert vergleicht. Es wird ein erster Phasenwert gebildet, wenn der Oszillatorwert den Vergleichswert überschreitet oder ein zweiter Phasenwert, wenn der Oszillatorwert gleich dem Vergleichswert ist oder ein dritter Phasenwert, wenn der Oszillatorwert den Vergleichswert unterschreitet.

In einer Ausführungsform der Steuerschaltung ist ein Quantisierer zum Empfang von gewichteten Phasenwerten und zur Erzeugung von zwei Quantisierungswerten enthalten, welche nach Wichtung zur Festlegung der Dauer des Zählintervalls des digitalen Oszillators vorgesehen sind.

Das Jitterverhalten kann weiter verbessert werden, wenn in der Steuerschaltung eine Rückkopplungsschaltung enthalten ist, welche zur Bildung von Differenzwerten zwischen den dem Quantisierer zugeführten Werte und den gewichteten Quantisierungswerten und zur Zuführung der invertierten Differenzwerte zu den gewichteten Phasenwerten vorgesehen ist. Diese Rückkopplungsschaltung stellt einen Sigma-Delta-Modulator dar, der einen häufigeren Wechsel in der dem digitalen Oszillator zugeführten Steueranweisung angibt.

Zur Formung des rückgewonnenen Taktsignals ist eine Impulsformerschaltung vorgesehen, die zum Empfang der Oszillatorwerte und zur Bildung einer Impulspause bei Unterschreiten eines Oszillatorwertes unter einen Schwellwert und sonst zur Bildung eines Impulsdaches vorgesehen ist.

Die Schaltung zur Rückgewinnung eines Taktsignals enthält noch einen Flankendetektor mit einer Abtastschaltung und einer Vergleichsschaltung. Die Abtastschaltung ist zur Abtastung des digitalen Eingangssignals und die Vergleichsschaltung durch Mustervergleich zur Detektierung von Flankenwechseln im abgetasteten Eingangssignal vorgesehen. Die Abtastschaltung erzeugt durch Abtastung Abtastwerte, die beispielsweise nach einer Begrenzung der Vergleichsschaltung zugeführt werden. In der Vergleichsschaltung werden begrenzte Abtastwerte mit mindestens einem Muster verglichen. Ist eine Anzahl von Abtastwerten gleich einem Muster, findet ein Flankenwechsel im Eingangssignal statt. Die von der Vergleichsschaltung ausgegebene und dem Phasendetektor zugeleitete Folge von Eingangswerte weist bei Flankenwechseln einen Zustandswechsel auf (z.B. von logisch "1" auf logisch "0" oder umgekehrt).

Die Erfindung bezieht sich auch auf eine Schaltung zur Rückgewinnung eines Taktsignals aus einem digitalen Eingangssignal und auf einen digitalen Regelkreis.

Ausführungsbeispiele der Erfindung werden nachstehend anhand der Figuren näher erläutert. Es zeigen:
- Fig. 1: ein Übertragungssystem mit Schaltungen zur Rückgewinnung eines Taktsignals,
- Fig. 2: ein erstes Ausführungsbeispiel einer Schaltung zur Rückgewinnung eines Taktsignals,
- Fig. 3: ein in der Schaltung nach Fig. 2 verwendeter Flankendetektor und
- Fig. 4: ein zweites Ausführungsbeispiel einer Schaltung zur Rückgewinnung eines Taktsignals.

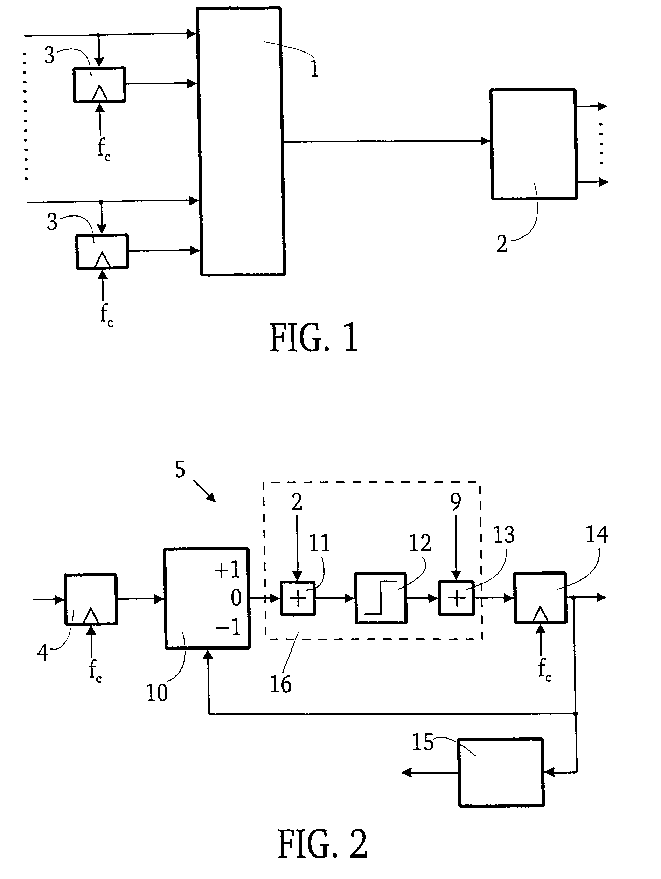

Das in Fig. 1 dargestellte Übertragungssystem enthält einen Multiplexer 1, einen Demultiplexer 2 und Schaltungen 3 zur Rückgewinnung eines Taktsignals. Der Multiplexer 1 fügt beispielsweise mehrere plesiochrone Signale in einen virtuellen Container der synchronen digitalen Hierachie ein. Hierbei muß jeweils eine Taktanpassung zwischen dem von einer Schaltung 3 rückgewonnenen Taktsignal und einem lokal erzeugten Taktsignal durchgeführt werden. Die Schaltung 3 empfängt noch ein lokal erzeugtes Taktsignal mit einer Abtastfrequenz f_{c}, die deutlich größer ist als die Frequenz des rückgewonnenen Taktsignals. Beispielsweise kann das lokale Taktsignal eine Abtastfrequenz von 19,44 MHz und die Frequenz des rückgewonnenen Taktsignals eine Nennfrequenz von 2,048 MHz aufweisen. Die virtuellen Container werden in einem STM-1-Rahmen eingefügt. Nach Empfang des virtuellen Containers im Demultiplexer 2 werden daraus wieder plesiochrone Signale gebildet.

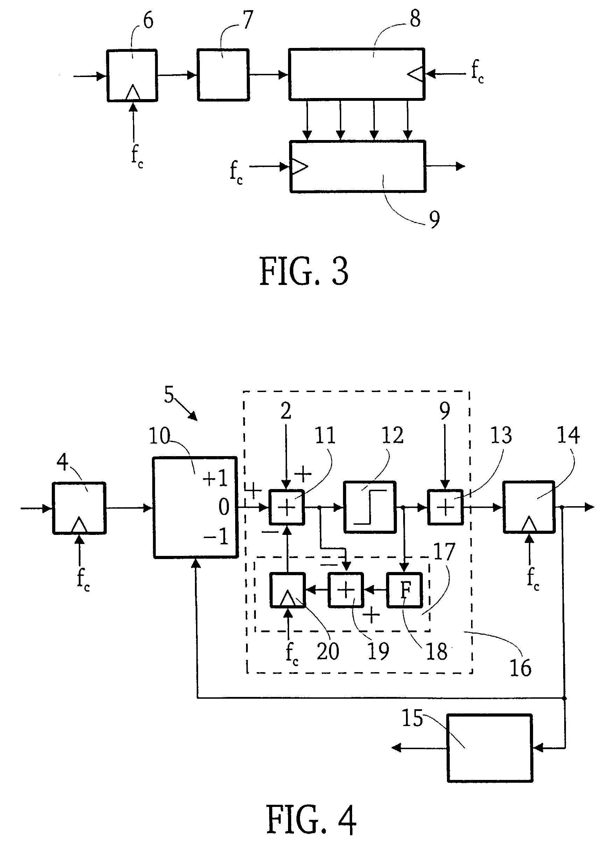

Das in Fig. 2 dargestellte Ausführungsbeispiel der Schaltung 3 zur Rückgewinnung eines Taktsignals enthält einen Flankendetektor 4 und einen digitalen Regelkreis 5. Ein Ausführungsbeispiel des Flankendetektors 4 ist in der Fig. 3 gezeigt. Dieser enthält eine Abtastschaltung 6, einen Begrenzer 7, ein Register 8 und eine Vergleichsschaltung 9. Die Abtastschaltung 6 tastet das vom Multiplexer 1 gelieferte Eingangssignal mittels des lokalen Taktsignals mit der Abtastfrequenz f_{c} ab. Die Abtastwerte werden einem Begrenzer 7 zugeleitet, der die Abtastwerte auf logisch "1" oder logisch "0" begrenzt. Eine Folge von vier begrenzten Abtastwerten werden kontinuierlich im Register 8 zwischengespeichert, dessen Takteingang das lokale Taktsignal erhält. Die Vergleichsschaltung 9, welcher ebenfalls das lokale Taktsignal zugeführt wird, gibt in Abhängigkeit von vorgegebenen Mustern Eingangswerte ab. Weisen die im Register gespeicherten Werte die Folge "1100" auf, so werden von der Vergleichsschaltung ein Eingangswert mit einer logischen "0" statt der vorher ausgegebenen logischen "1" erzeugt. Weist das Muster die Folge "0011" auf, so findet ein umgekehrter Zustandswechsel in der Folge der Eingangswerte statt.

Die Folge der Eingangswerte wird einem im digitalen Regelkreis 5 enthaltenem Phasendetektor 10 zugeleitet. Weiter umfaßt der in der Fig. 2 dargestellte digitale Regelkreis 5 einen Addierer 11, einen Quantisierer 12, einen Addierer 13, einen als Zähler ausgebildeten digitalen Oszillator 14 und eine Impulsformerschaltung 15. Dem Phasendetektor 10 werden außer den Eingangswerten auch die vom digitalen Oszillator 14 erzeugten Oszillatorwerte zugeführt. Der Phasendetektor 10 vergleicht bei einem Zustandswechsel von logisch "1" auf logisch "0" oder umgekehrt in der Folge der Eingangswerte den anliegenden Oszillatorwert mit einem Vergleichswert. Bei dem oben angegebenen Frequenzverhältnis kann der Vergleichswert z.B. gleich 5 sein. Ist der Vergleichswert kleiner als der Oszillatorwert wird der Phasenwert "+1" vom Phasendetektor 10 abgegeben. Sind der Vergleichswert und der Oszillatorwert gleich, wird der Phasenwert "0" vom Phasendetektor 10 erzeugt. Der Phasendetektor liefert einen Phasenwert "-1", wenn der Vergleichswert größer als der Oszillatorwert ist.

Beispielsweise bilden die Schaltelemente 11 bis 13 eine Steuerschaltung 16 zur Bildung von Steueranweisungen für den digitalen Oszillator 14. In dem Addierer 11 wird der Phasenwert mit einem konstanten Wert "2" addiert (Wichtung), so daß sich ein gewichteter Phasenwert ergibt. Der Quantisierer 12 erzeugt einen Quantisierungswert "1", wenn der vom Addierer 11 gelieferte Wert größer oder gleich dem Wert "2" ist. in den anderen Fällen wird der Quantisierungswert "0" vom Quantisierer 12 ausgegeben. in dem nachfolgenden Addierer 13 wird der Quantisierungswert mit dem konstanten Wert "9" addiert. Dieser vom Addierer 13 dem digitalen Oszillator 14 gelieferte Wert gibt das Zählintervall für den als Zähler ausgebildeten digitalen Oszillator 14 an. Der Zähler 14, der auch das lokale Taktsignal erhält, zählt entweder 9 oder 10 Zähleinheiten, bis er wieder auf seinen Anfangswert zurückgesetzt wird.

Die Impulsformerschaltung 15, welche das rückgewonnene Taktsignal mit der Nennfrequenz 2,048 MHz formt, erhält ebenfalls die Oszillatorwerte vom digitalen Oszillator 14. Die Impulsformerschaltung gibt ein Impulsdach aus, wenn der Oszillatorwert den Schwellwert "5" unterschreitet, und sonst eine Impulspause. Der Schwellwert wird ebenso wie der Vergleichswert durch das Frequenzverhältnis bestimmt.

In Fig. 4 ist eine um einige Schaltelemente gegenüber der Fig. 2 erweiterte Schaltung 3 zur Rückgewinnung eines Taktsignals dargestellt. Diese enthält in der Steuerschaltung 16 eine Rückkopplungsschaltung oder Sigma-Delta-Modulator 17. Die Rückkopplungsschaltung 17 dient zur Verbesserung des Jitterverhaltens. Die Rückkopplungsschaltung 17 enthält einen Multiplizierer 18, einen Subtrahierer 19 und ein Verzögerungsglied 20. Der Subtrahierer 19 erhält die gewichteten Phasenwerte vom Addierer 11 und die mit dem Multiplizierer 18 gewichteten Quantisierungswerte. Ein Differenzwert wird über das Verzögerungsglied 20, welches noch das lokale Taktsignal erhält, dem Addierer 11 invertiert zugeführt. Der Faktor F mit dem der Multiplizierer 18 die Quantisierungswerte erzeugt, kann gleich "2" oder "4" sein. Das beste Jitterverhalten ergab sich beim Faktor "4". Ist der Faktor gleich "4", erzeugt der Quantisierer 12 erst dann einen Quantisierungswert von "1", wenn der vom Addierer 11 gelieferte Wert größer oder gleich dem Wert "4" ist.

## Patentansprüche

1. Übertragungssystem mit einer Schaltung (3) zur Rückgewinnung eines Taktsignals aus einem digitalen Eingangssignal mittels eines digitalen Regelkreises (5), der
- einen Phasendetektor (10) zum Empfang von Eingangswerten, die aus Abtastwerten des digitalen Eingangssignals abgeleitet sind, und von Oszillatorwerten eines digitalen Oszillators (14) und zur Erzeugung von mindestens zwei Phasenwerten in Abhängigkeit von der Größe der Oszillatorwerte bei Auftreten eines Zustandswechsels in der Folge der Eingangswerte und
- einer Steuerschaltung (16) enthält, welche zur Festlegung der Dauer der Zählintervalle des digitalen Oszillators (14) in Abhängigkeit von den Phasenwerten vorgesehen ist.

2. Übertragungssystem nach Anspruch 1,
dadurch gekennzeichnet,
daß der Phasendetektor (10) bei Auftreten eines Zustandswechsels in der Folge der Eingangswerte
- zum Vergleich des anliegenden Oszillatorwertes mit einem Vergleichswert und
- zur Bildung eines ersten Phasenwertes, wenn der Oszillatorwert den Vergleichswert überschreitet oder
- zur Bildung eines zweiten Phasenwertes, wenn der Oszillatorwert gleich dem Vergleichswert ist oder
- zur Bildung eines dritten Phasenwertes vorgesehen ist, wenn der Oszillatorwert den Vergleichswert unterschreitet.

3. Übertragungssystem nach Anspruch 1 oder 2,
dadurch gekennzeichnet,
daß die Steuerschaltung (16) einen Quantisierer (12) zum Empfang von gewichteten Phasenwerten und zur Erzeugung von zwei Quantisierungswerten, welche nach Wichtung zur Festlegung der Dauer des Zählintervalls des digitalen Oszillators (14) vorgesehen sind.

4. Übertragungssystem nach Anspruch 3,
dadurch gekennzeichnet,
daß die Steuerschaltung (16) eine Rückkopplungsschaltung (17) enthält, welche zur Bildung von Differenzwerten zwischen den dem Quantisierer (12) zugeführten Werte und den gewichteten Quantisierungswerten und zur Zuführung der invertierten Differenzwerte zu den gewichteten Phasenwerten vorgesehen ist.

5. Übertragungssystem nach einem der vorhergehenden Anspüche,
dadurch gekennzeichnet,
daß eine das rückgewonnene Taktsignal ausgebende Impulsformerschaltung (4) zum Empfang der Oszillatorwerte und zur Bildung einer Impulspause bei Unterschreiten eines Oszillatorwertes unter einen Schwellwert und sonst zur Bildung eines Impulsdaches vorgesehen ist.

6. Übertragungssystem nach einem der vorhergehenden Anspüche,
dadurch gekennzeichnet,
daß die Schaltung (3) zur Rückgewinnung eines Taktsignals einen Flankendetektor (4) mit einer Abtastschaltung (6) und einer Vergleichsschaltung (9) enthält und
daß die Abtastschaltung (6) zur Abtastung des digitalen Eingangssignals und die Vergleichsschaltung (9) durch Mustervergleich zur Detektierung von Flankenwechseln im abgetasteten Eingangssignal vorgesehen ist.

7. Schaltung (3) zur Rückgewinnung eines Taktsignals aus einem digitalen Eingangssignal mittels eines digitalen Regelkreises (5), der
- einen Phasendetektor (10) zum Empfang von Eingangswerten, die Abtastwerte des digitalen Eingangssignals darstellen, und von Oszillatorwerten eines digitalen Oszillators (14) und zur Erzeugung von mindestens zwei Phasenwerten in Abhängigkeit von der Größe der Oszillatorwerte bei Auftreten eines Zustandswechsels im Eingangssignals und
- einer Steuerschaltung (16) enthält, welche zur Festlegung der Dauer der Zählintervalle des digitalen Oszillators (14) in Abhängigkeit von den Phasenwerten vorgesehen ist.

8. Digitaler Regelkreises (5) mit
- einen Phasendetektor (10) zum Empfang von Eingangswerten, die Abtastwerte des digitalen Eingangssignals darstellen, und von Oszillatorwerten eines digitalen Oszillators (14) und zur Erzeugung von mindestens zwei Phasenwerten in Abhängigkeit von der Größe der Oszillatorwerte bei Auftreten eines Zustandswechsels im Eingangssignals und
- einer Steuerschaltung (16), welche zur Festlegung der Dauer der Zählintervalle des digitalen Oszillators (14) in Abhängigkeit von den Phasenwerten vorgesehen ist.
